# EUROPÄISCHE PATENTSCHRIFT

(11) **EP 0 886 305 B1**
(45) Veröffentlichungstag und Bekanntmachung des Hinweises auf die Patenterteilung: **19.12.2007**
(21) Anmeldenummer: 98890167.4
(22) Anmeldetag: 29.05.1998
(51) Int. Cl.: H01L 21/00

(54) **Verfahren und Vorrichtung zum Handhaben von scheibenförmigen Gegenständen, insbesondere Silizium-Wafer**
Method and apparatus for handling disc substrates, e.g. silicon wafers
Méthode et appareil de manipulation de substrats discoides, en particulier galettes de silicium

(30) Priorität: 18.06.1997 AT 106097
(43) Veröffentlichungstag der Anmeldung: 23.12.1998
(73) Patentinhaber: SEZ AG, 9500 Villach (AT)
(72) Erfinder: Sumnitsch, Franz, 9020 Klagenfurt (AT)
(74) Vertreter: Beer, Manfred

(56) Entgegenhaltungen:
- EP-A- 0 250 064
- EP-A- 0 634 785
- EP-A- 0 676 793
- EP-A- 0 821 404
- EP-A- 0 833 374
- EP-A- 0 877 414
- WO-A-97/08743
- US-A- 4 790 258

## Beschreibung

Die Erfindung betrifft einen Träger für einen scheibenförmigen Gegenstand.

Mit dem Träger für einen scheibenförmigen Gegenstand gemäß der Erfindung können scheibenförmige Gegenstände während Behandlungsschritten gehalten und in Drehung versetzt werden. Insbesondere sind solche Träger (chucks) dazu bestimmt (Silizium)-Wafer zu halten und in Drehung zu versetzen, während sie behandelt, zB geätzt, poliert und gespült werden.

Träger dieser Gattung gibt es in zwei grundsätzlichen Ausführungsformen. Eine Ausführungsform besitzt in der dem Gegenstand zugekehrten Seite des Trägers Stifte (US-A-4 903 717 und US-A-5 513 668), von welchen die scheibenförmigen Gegenstände seitlich gestützt werden, während sie vorwiegend nach dem Bernoulli-Prinzip unter der Wirkung eines aus einer Ringdüse austretenden Gases am Träger gehalten werden. Bei einer anderen Ausführungsform solcher Träger für scheibenförmige Gegenstände (WO 97/03457) sind solche Stifte nicht vorgesehen, da der Gegenstand an dem Träger durch Unterdruck in Anlage an beispielsweise ringförmige Vorsprünge an der dem Gegenstand zugekehrten Fläche des Trägers gehalten wird.

Das Auflegen eines scheibenförmigen Gegenstandes, insbesondere eines (Silizium-) Wafer, auf einen Träger und das Abnehmen des Gegenstandes von dem Träger war bislang relativ umständlich. Grund hiefür ist, daß bei mit Stiften versehenen Trägern zwischen dem Gegenstand und der ihm zugekehrten Fläche des Trägers ein nur sehr kleiner Spalt vorliegt, und daß bei Trägern, an welchen Gegenstände mittels Unterdruck festgehalten werden, praktisch kein Spalt vorliegt. Daher war es bisher nicht möglich, die bekannten Löffel oder Gabeln, mit welchen scheibenförmige Gegenstände, insbesondere Silizium-Wafer, von unten her erfaßt werden, zu verwenden, um Wafer auf den Träger aufzulegen und von diesem wieder abzunehmen. Solche Löffel werden aber dazu verwendet, Wafer aus Tragehorden in Vorratsbehältern (carrier-boxes) herauszunehmen und wieder in diese zurückzulegen.

Um dieses Problem zu lösen, sind verschiedene Greifvorrichtungen für scheibenförmige Gegenstände (Wafer) vorgeschlagen worden. Beispielsweise kann auf den in der AT 000 640 U1 oder der WO 95/11518 gezeigten Greifer verwiesen werden. Solche Greifer arbeiten zufriedenstellend, insbesondere wenn zwischen dem scheibenförmgien Gegenstand und dem Träger ein - wenn auch kleiner - Spalt vorhanden ist, machen es aber erforderlich, daß sowohl zum Auflegen des scheibenförmigen Gegenstandes als auch für das Abnehmen des scheibenförmigen Gegenstandes jeweils ein zweiter Greifer (Löffel) zum Entleeren bzw. Befüllen der Tragehorden in Vorratsbehältern verwendet wird.

In der EP 0 634 785 A wird eine Vorrichtung zum Bearbeiten von Wafern beschrieben, bei der ein Träger in einer Kammer vorgesehen ist. Der Träger für einen Wafer kann durch einen Motor in Drehung versetzt werden. In einer Ausführungsform des Trägers sind Hebestifte vorgesehen, die in Bohrungen aufgenommen sind. Die Wafer-Hebestifte können sich während der Übertragung des Wafers auf den oder von dem Träger relativ zum Träger bewegen, um Wafer aus einer Vertiefung des Trägers zu heben und von der Oberfläche des Trägers frei kommen zu lassen. Irgendwelche Hinweise, wie diese Wafer-Hebestifte betätigt werden können, sind in der EP 0 634 785 A nicht geoffenbart.

Hebestifte an Vorrichtungen zum Halten von Halbleiterwafern sind aus der EP 0 250 064 A und der EP 0 676 793 A bekannt. Die Träger dieser Vorrichtungen werden nicht in Drehung versetzt.

Aufgabe der Erfindung ist es, einen Träger vorzuschlagen, mit dem das Aufsetzen und Abnehmen eines scheibenförmigen Gegenstandes auf den und von dem Träger vereinfacht ist.

Erfindungsgemäß wird diese Aufgabe mit den Merkmalen des unabhängigen Vorrichtungshauptanspruches 1 gelöst.

Bevorzugte und vorteilhafte Ausgestaltungen der Erfindung sind Gegenstand der Unteransprüche.

Mit dem erfindungsgemäßen Träger ist es nunmehr möglich, zum Aufsetzen und Abnehmen eines Gegenstandes beispielsweise die bekannten Löffel oder Gabeln zu verwenden, mit denen scheibenförmige Gegenstände üblicherweise aus Tragehorden in Behältern entnommen werden. Die Erfindung erspart in vorteilhafter Weise sowohl beim Auflegen als auch beim Abnehmen des scheibenförmigen Gegenstandes einen Umgreifschritt, da der scheibenförmige Gegenstand (z.B. ein Siliziumwafer) mit demselben Löffel, mit dem er aus einer Tragehorde (carrier-box) entnommen wurde, auf den Träger (chuck) aufgesetzt werden kann. Analoges gilt für das Abnehmen des scheibenförmigen Gegenstandes vom Träger und das Zurücklegen in die Tragehorde im Behälter.

Dies ist möglich, da der scheibenförmige Gegenstand von der ihm zugekehrten Fläche des Trägers unter Ausbilden eines Spaltes abgehoben werden kann, so daß eine Vorrichtung zum Erfassen des scheibenförmigen Gegenstandes (z.B. ein bekannter Löffel oder der aus der WO 95/11518 bekannte Greifer) zwischen dem Träger und dem Gegenstand eingeführt werden kann.

Von Vorteil ist, daß der scheibenförmige Gegenstand während der Behandlung (z.B. Ätzen, Polieren usw. von Silizium-Wafer) auf die ihm zugekehrte Fläche des Trägers abgesenkt werden kann und somit der bei der Behandlung/Bearbeitung unerwünschte Spalt verkleinert wird.

Weitere Merkmale und Einzelheiten der Erfindung ergeben sich aus der nachstehenden Beschreibung, in der auf das in der Zeichnung gezeigte Ausführungsbeispiel eines erfindungsgemäßen Trägers, der in der Zeichnung schematisch dargestellt ist, Bezug genommen wird. Es zeigt:
- Fig. 1: einen Träger in Schrägansicht,
- Fig. 2: einen Schnitt längs der Linie II - II von Fig. 3 und
- Fig. 3: eine Draufsicht auf einen Träger.

Der in den Zeichnungsfiguren gezeigte Träger 1 (chuck) ist ohne Stifte (WO 97/03457) ausgebildet, d.h. er besitzt in seiner dem Gegenstand zugekehrten, oben liegenden Fläche keine Stifte, die am seitlichen Rand des scheibenförmigen Gegenstandes (Silizium-Wafer) angreifen und diesen seitlich abstützen. In der dem Gegenstand zugekehrten Fläche 4 des Trägers 1 ist eine ringförmige Düse 3 vorgesehen, aus der gasförmiges Medium, meist Stickstoff, austritt.

Wegen weiterer Einzelheiten bezüglich des Aufbaus und der Funktion von Trägern, an welchen die scheibenförmigen Gegenstände durch angelegten Unterdruck gehalten werden, wird auf die WO 97/03457 verwiesen.

Der Träger 1 kann auch eine Konstruktion aufweisen, bei der in seiner dem Gegenstand zugekehrten Fläche 4 Stifte für das seitliche Abstützen des scheibenförmigen Gegenstandes vorgesehen sind (US-A-4 903 717). Diese Stifte können, so wie in der US-A-5 513 668 beschrieben, auch radial verstellbar sein.

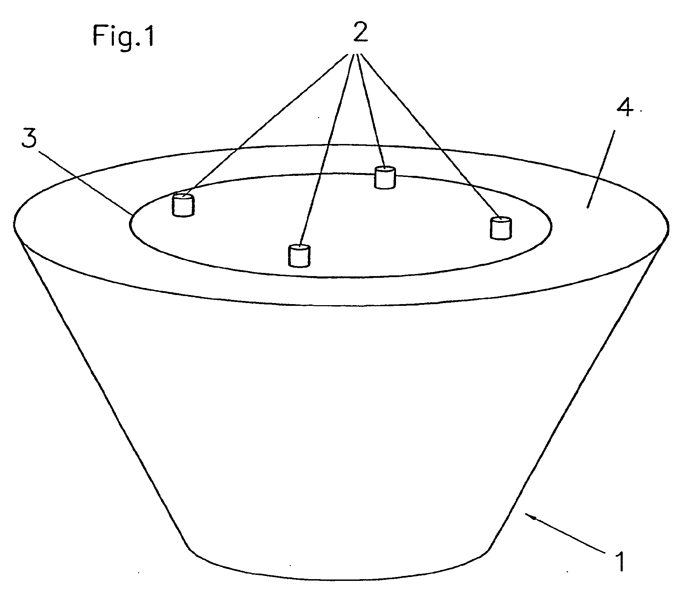

Innerhalb der ringförmigen Düse 3 sind mehrere, in einem bevorzugten Ausfürungsbeispiel vier, Stifte oder Zapfen 2 vorgesehen, die in Fig. 1 in ihrer über die dem Gegenstand zugekehrte Fläche 4 des Trägers 1 ausgefahrenen Stellung gezeigt sind.

Den Stiften oder Zapfen 2 ist ein in Fig. 1 nicht gezeigter gemeinsamer Antrieb zugeordnet, der im Inneren des Trägers 1 aufgenommen ist, um die Stifte oder Zapfen 2 über die dem Gegenstand zugekehrte Fläche 4 des Trägers 1 auszufahren bzw. in diese Fläche 4 zurückzuziehen.

Zum Abnehmen bzw. Auflegen eines scheibenförmigen Gegenstandes wird der Träger 1 so gedreht, daß die ausgefahrenen Stifte oder Zapfen 2 die radial zum Träger 1 ausgerichtete Bewegung eines, z.B. löffelartigen, Gerätes, mit dem scheibenförmige Gegenstände (Silizium-Wafer) bewegt werden, nicht behindern.

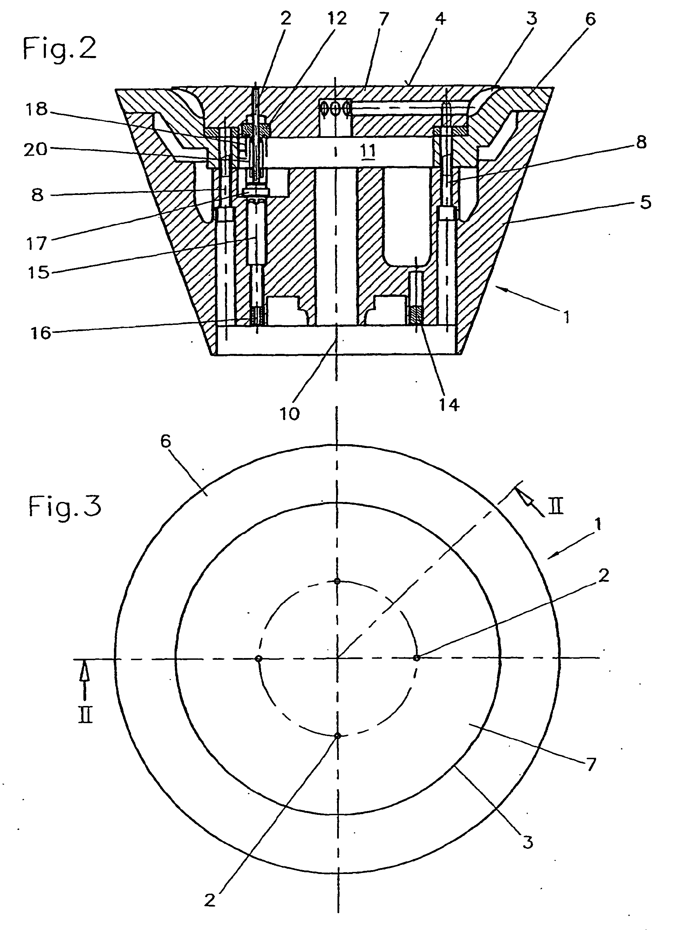

In Fig. 2 ist ein Antrieb für die Stifte oder Zapfen 2 gezeigt. Obwohl für die Ausführung des Antriebes nicht wesentlich, ist in Fig. 2 gezeigt, daß der Träger 1 aus drei Teilen 5, 6 und 7 zusammengesetzt ist, die mit Schrauben 8 miteinander verbunden sind.

Fig. 2 zeigt auch, daß die ringförmige Düse 3 von den einander zugewendeten Bereichen der Teile 6 und 7 begrenzt wird.

Die Stifte oder Zapfen 2 sind im Teil 7 parallel zur Achse 10 des Trägers 1 verschiebbar. Die Bohrungen, in denen die Stifte oder Zapfen 2 geführt sind, sind zur mit Druckgas beaufschlagten Kammer 11 durch Dichtungen 12 abgedichtet.

Im Teil 5 des Trägers 1 ist ein Ring 14 angeordnet, der mit Hilfe einer nicht gezeigten, zB hydraulischen oder pneumatischen, Betätigungseinrichtung (Pneumatikzylinder od. Hydraulikzylinder) in Richtung der Achse 10 des Trägers 1 verschoben werden kann. Jedem Stift oder Zapfen 2 ist eine Schubstange 15 zugeordnet, die mit einem Außengewindeansatz 16 in eine Gewindebohrung im Ring 14 geschraubt ist. Die Schubstangen 15 sind in entsprechend ihrer Außenkontur gestuften Bohrungen im Teil 5 des Trägers 1 parallel zur Achse 10 des Trägers 1 verschiebbar aufgenommen.

Das vordere Ende jeder Schubstange 15 ist einer Tasse 17 an den Stiften oder Zapfen 2 zugewendet. Die Schubstangen 15 greifen beim Betätigen des Ringes 14 an diesen Tassen 17 an, so daß die Stifte oder Zapfen 2 über die dem Gegenstand zugekehrte Fläche 4 des Trägers 1 hinaus vorgeschoben werden.

Das Rückstellen der Zapfen oder Stiften 2 wird von Druckschraubenfedern 18 besorgt, die sich an den Dichtungen 12 und an den Tassen 17 abstützen.

Innerhalb jeder Druckschraubenfeder 18 ist ein Faltenbalg 20 vorgesehen, der einerseits an der Dichtung 12 und anderseits an der Tasse 17 der Stifte 2 dicht befestigt ist. Jeder Faltenbalg 20 umgibt den in der Kammer 11 liegenden Abschnitt der Stifter oder Zapfen 2.

Zusammenfassend kann ein bevorzugtes Ausführungsbeispiel des erfindungsgemäßen Trägers wie folgt beschrieben werden:

In einem Träger 1 für scheibenförmige Gegenstände (Silizium-Wafer) sind der dem Gegenstand zugekehrten Fläche 4 des Trägers 1 mehrere, als Stifte oder Zapfen 2 ausgebildete, Hebeeinrichtungen vorgesehen, die senkrecht zur dem Gegenstand zugekehrten Fläche 4 des Trägers 1 ausgefahren und wieder in diese Fläche 4 zurückgezogen werden können. Durch diese Zapfen oder Stiften 2 kann der Abstand zwischen dem Gegenstand und dem Träger 1 zum Auflegen und Abnehmen von Gegenständen auf den Träger 1 vergrößert werden, so daß insbesondere beim Handhaben von Silizium-Wafer die für das Einsetzen und Entnehmen derselben in/aus Aufnahmehorden verwendeten, löffelartigen Geräte verwendet werden können.

## Patentansprüche

1. Träger (1) für einen scheibenförmigen Gegenstand, mit welchem der scheibenförmige Gegenstand während Behandlungsschritten gehalten und in Drehung versetzt werden kann, mit einer dem Gegenstand zugekehrten Fläche (4), mit wenigstens einer Einrichtung zum Festhalten des Gegenstandes an der ihm zugekehrten Fläche (4) des Trägers (1) und mit Abstandsmitteln (2), um den Abstand des scheibenförmigen Gegenstandes von der ihm zugekehrten Fläche (4) des Trägers (1) vergrößern und verkleinern zu können, wobei die Abstandsmittel (2) aus der dem Gegenstand zugekehrten Fläche (4) des Trägers (1) ausfahrbare Stifte oder Zapfen (2) sind, die in zur Achse (10) des Trägers (1) parallelen Bohrungen im Träger (1), oder in einem Teil (7) desselben verschiebbar geführt sind, wobei: allen Stiften oder Zapfen (2) ein gemeinsamer Antrieb (14, 15) zugeordnet ist, zum Betätigen der Stifte oder Zapfen (2) Schubstangen (15) vorgesehen sind, die mit einem gemeinsamen Betätigungsorgan (14) verbunden sind, das Betätigungsorgan ein im Träger (1) verstellbarer Ring (14) ist, dem Ring (14) seinerseits ein Antrieb, z.B. ein Druckmittelzylinder, insbesondere ein Pneumatikzylinder, zugeordnet ist, und die Stifte oder Zapfen (2) durch Federmittel (18) in ihre in den Träger (1) zurückgezogene Stellung belastet sind.

2. Träger nach Anspruch 1, **dadurch gekennzeichnet, daß** die ausfahrbaren Stifte oder Zapfen (2) innerhalb einer ringförmigen, in der dem Gegenstand zugekehrten Fläche (4) des Trägers (1) vorgesehenen Düse (3) angeordnet sind.

3. Träger nach Anspruch 1 oder 2, **dadurch gekennzeichnet, daß** die ausfahrbaren Stifte oder Zapfen (2) über den Umfang der dem Gegenstand zugekehrten Fläche (4) des Trägers (1) gleichmäßig verteilt angeordnet sind.

4. Träger nach Anspruch 1, **dadurch gekennzeichnet, daß** die Schubstangen (15) mit dem Ring (14) verschraubt sind.

5. Träger nach einem der Ansprüche 1 bis 4, **dadurch gekennzeichnet, daß** die den Schubstangen (15) benachbarten Enden der Stifte oder Zapfen (2) Tassen (17) aufweisen.

6. Träger nach einem der Ansprüche 1 bis 5, **dadurch gekennzeichnet, daß** die Stifte oder Zapfen (2) einer im Träger (1) vorgesehenen Kammer (11), über welche die Ringdüse (3) mit Druckgas beaufschlagt wird, innerhalb von Faltenbälgen (20) angeordnet sind.

7. Träger nach Anspruch 6, **dadurch gekennzeichnet, daß** die Faltenbälge (20) innerhalb der die Stifte oder Zapfen (2) beaufschlagenden Federn (18), die vorzugsweise Schraubenfedern (18) sind, angeordnet sind.

## Claims

1. Chuck (1) for a disk-like object by means of which the disk-like object is held during treating steps and is rotated with a surface (4) that faces toward the object, with at least one means for holding the object on the surface (4) of the chuck that faces toward the object and with distance means (2) in order to increase and decrease the distance of the disk-like object from the surface (4) of the chuck (1) that faces toward it, whereby the distance means (2) are pins or pegs (2) which may be extended from the surface (4) of the chuck (1) that faces toward the object and which are displaceably guided in holes in the chuck (1) that are parallel to the axis (10) of the chuck (1) or in a part (7) thereof, whereby to all pins or pegs (2) is coordinated a common drive (14, 15), whereby for actuating the pins or pegs (2) push-bars (15) are provided which are connected to a common actuating means (14), whereby the actuating means is a ring (14) displaceable in the chuck (1), whereby to the ring (14) on his side is coordinated a drive, for example a pressure cylinder, in particular a pneumatic cylinder, and whereby the pins or pegs (2) are loaded by spring means (18) into their position retracted into the chuck (1).

2. Chuck according to claim 1, **characterized in that** the extendable pins or pegs (2) are disposed inside a ring shaped nozzle (3) which is provided in the surface (4) of chuck (1) that faces toward the object.

3. Chuck according to claim 1 or 2, **characterized in that** the extendable pins or pegs (2) are uniformly distributed around the circumference of the surface (4) of chuck (1) that faces toward the object.

4. Chuck according to claim 1, **characterized in that** the push-bars (15) are screwed to the ring (14).

5. Chuck according to one of claims 1 to 4, **characterized in that** the ends of the pins or pegs (2) adjacent to the push-bars (15) are provided with cups (17).

6. Chuck according to one of claims 1 to 5, **characterized in that** the pins or pegs (2) in the region of a chamber (11) that is provided in the chuck (1) by means of which chamber compressed gas is applied to the ring-shaped nozzle (3), are arranged inside of folded bellows (20).

7. Chuck according to claim 6, **characterized in that** the folded bellows (20) are arranged inside of the springs (18) which load pins or pegs (2), which springs (18) preferably are coil-springs (18).

## Revendications

1. Support (1) pour un objet en forme de disque, au moyen duquel l'objet en forme de disque est maintenu pendant des phases de traitement et peut être mis en rotation, présentant une surface (4) tournée vers l'objet, au moins un dispositif pour le maintien de l'objet contre la surface (4) tournée vers lui du support (1), et des moyens d'écartement (2) pour pouvoir agrandir et diminuer l'espacement entre l'objet en forme de disque et la surface (4) tournée vers lui du support (1), lesdits moyens d'écartement (2) étant des tiges ou des goupilles (2) rétractables sous la surface (4) du support (1) tournée vers l'objet, coulissant dans des alésages du support (1) parallèles à l'axe (10) du support (1), ou dans une partie (7) de ce dernier, toutes les tiges ou goupilles (2) dépendant d'un entraînement commun (14, 15), des barres de poussée (15) étant prévues pour l'actionnement des tiges ou goupilles (2), lesquelles sont reliées à un organe d'actionnement commun (14), l'organe d'actionnement étant une bague (14) réglable dans le support (1), la bague (14) dépendant quant à elle d'un entraînement, par exemple un cylindre à fluide sous pression, en particulier un vérin pneumatique, et les tiges ou goupilles (2) étant contraintes par des moyens à ressort (18) dans leur position de rétractation dans le support (1).

2. Support selon la revendication 1, **caractérisé en ce que** les tiges ou goupilles coulissantes (2) sont disposées à l'intérieur d'une buse (3) annulaire prévue dans la surface (4) du support (1) tournée vers l'objet.

3. Support selon la revendication 1 ou la revendication 2, **caractérisé en ce que** les tiges ou goupilles coulissantes (2) sont régulièrement réparties sur le tour de la surface (4) du support (1) tournée vers l'objet.

4. Support selon la revendication 1, **caractérisé en ce que** les barres de poussée (15) sont vissées à la bague (14).

5. Support selon l'une des revendications 1 à 4, **caractérisé en ce que** les extrémités des tiges ou goupilles (2) adjacentes aux barres de poussée (15) sont pourvues de tasses (17).

6. Support selon l'une des revendications 1 à 5, **caractérisé en ce que** les tiges ou goupilles (2) sont disposées à l'intérieur de soufflets (20) au niveau d'une chambre (11) prévue dans le support (1) et par laquelle la buse annulaire (3) est alimentée en gaz sous pression.

7. Support selon la revendication 6, **caractérisé en ce que** les soufflets (20) sont disposés à l'intérieur des ressorts (18) contraignant les tiges ou goupilles (2), lesquels sont de préférence des ressorts hélicoïdaux (18).
